# EUROPEAN PATENT SPECIFICATION

(11) **EP 4 081 885 B1**
(45) Date of publication and mention of the grant of the patent: **03.09.2025**
(21) Application number: 20828748.2
(22) Date of filing: 16.12.2020
(51) Int. Cl.: G06F 3/042, G06F 1/16, H03K 17/94, G01S 17/02, G01S 7/481, G01S 17/08, H10F 55/255

(54) **A SENSING SYSTEM**
SENSORSYSTEM
SYSTÈME DE CAPTEUR

(30) Priority: 26.12.2019 US 201962953657 P
(43) Date of publication of application: 02.11.2022
(73) Proprietor: ams International AG, 8645 Jona (CH)
(72) Inventor: KOSCHIER, Markus, 5656 AE Eindhoven (NL)
(74) Representative: Tergau & Walkenhorst Intellectual Property GmbH
(86) International application number: PCT/EP2020/086493
(87) International publication number: WO 2021/130083

(56) References cited:
- US-A1- 2012 133 617
- US-A1- 2012 133 956
- US-A1- 2015 109 785
- US-A1- 2016 050 746

## Description

### Technical Field of the Disclosure

The disclosure relates to a sensing system suitable for use in an electronic device, particularly but not exclusively to a time-of-flight sensing system or a proximity sensing system suitable for use in a mobile phone.

### Background of the Disclosure

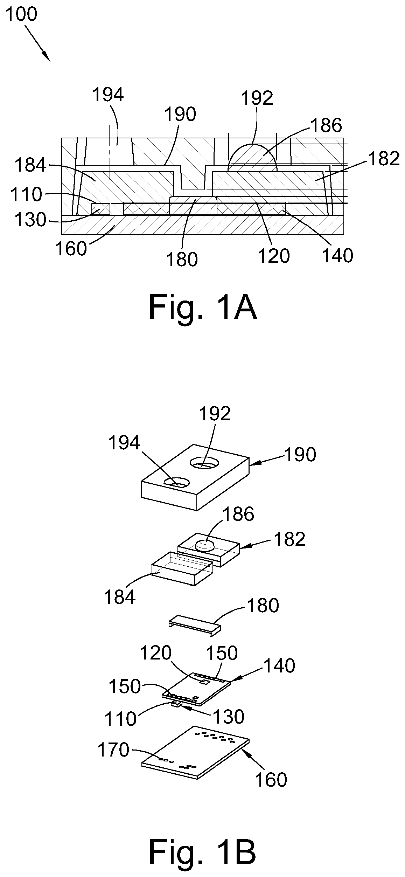

An example of a known sensing system 100 is illustrated in Figures 1A and 1B. The known sensing system 100 comprises an emitter 110 configured to emit electromagnetic radiation and a detector 120 configured to detect electromagnetic radiation. The emitter 110 is located on a first die 130 and the detector 120 is located on a second die 140. The first and second dies 130, 140 are located on a substrate 160. The substrate 160 may form part of a printed circuit board (not shown) of an electronic device (not shown). The substrate 160 comprises electrical contacts 170 for electrically connecting the substrate 160 to other circuitry (e.g. one or more processors of the sensing system 100 and/or electronic device). The dies 130, 140 comprise electrical contacts 150 for electrically connecting the dies 130, 140 to the substrate 160 and other circuitry (e.g. a processor of the electronic device). The known sensing system 100 comprises a shield 180 located between the emitter 110 and the detector 120. The shield 180 solely acts to block at least some electromagnetic radiation from propagating directly from the emitter 110 to the detector 120 to reduce noise in the detector signal. The known sensing system 100 further comprises first and second casings 182, 184 that are substantially transparent to operating wavelengths of the emitter 110 and detector 120 (e.g. visible and/or infrared wavelengths of electromagnetic radiation). The first casing 182 is configured to protect the detector 120 and includes a lens 186 for capturing and focusing incident electromagnetic radiation onto the detector 120. The second casing 184 is configured to protect the emitter 110. The known sensing system 100 further comprises a cap 190 comprising a first aperture 192 configured to transmit electromagnetic radiation through to the detector 120 and a second aperture 194 configured to allow electromagnetic radiation emitted by the emitter 110 to exit the sensing system 100. The shield 180 is typically made from plastic and is glued to the sensing system 100 before the first and second casings 182, 184 and the cap 190 are installed over the shield 180.

US2015/109785 A1 discloses a wafer level optical proximity sensor including an optical emitter and a photdetector arranged on a substrate and separated by an opaque wall.

US2016/0050746 A1 discloses a printed circuit assembly (PCA) comprising a PCB and a group of components comprising an emitter, a detector and an IC, where multiple PCAs are arranged along each edge of a panel for use in an optical touch sensing system.

It is an aim of the present disclosure to provide a sensing system that addresses one or more problems associated with known sensing systems, or at least provide a useful alternative.

### Summary

In general, the invention relates to a sensing system comprising an emitter, a detector and an electronic component configured to interact with a circuitry of the sensing system. The electronic component is located at least partially between the emitter and the detector. The electronic component blocks (e.g. absorbs and/or redirects) an amount of electromagnetic radiation that would otherwise propagate directly from the emitter to the detector without leaving the sensing system. The electronic component advantageously not only performs its standard function of interacting with a circuitry of the sensing system, but also blocks at least some electromagnetic radiation from travelling directly from the emitter to the detector. This removes the need for the shield of known sensing systems, which advantageously enables a more compact sensing system. The sensing system according to the invention comprises at least one less component than known sensing systems, thereby simplifying and reducing the cost of manufacture of the sensing system. The electronic component may be sized, shaped and/or positioned to at least partially block a line of sight from the emitter to the detector. The electronic component may comprise a material that is substantially opaque (e.g. blocks about 90% or more of incident radiation) to wavelengths of electromagnetic radiation that are emitted by the emitter and detected by the detector.

According to one aspect of the present disclosure, there is provided a sensing system comprising an emitter configured to emit electromagnetic radiation and a detector configured to detect electromagnetic radiation. The sensing system further comprises an electronic component configured to interact with a circuitry of the sensing system. The electronic component is located at least partially between the emitter and the detector. The electronic component reduces an amount of electromagnetic radiation propagating from the emitter to the detector.

Known sensing systems include a shield located between the emitter and the detector.

The sole purpose of the shield is to reduce the detection of electromagnetic radiation that propagates directly from the emitter to the detector. The shield does this by blocking (e.g. redirecting and/or absorbing) at least some of the radiation that is incident upon the electronic component. Known sensing systems also include electronic components that are solely used for their electronic function. By locating the electronic component at least partially between the emitter and the detector, the electronic component not only performs its standard function of interacting with a circuitry of the sensing system, but also reduces the detection of electromagnetic radiation that propagates from the emitter to the detector without leaving the sensing system. This removes the need for the shield, which advantageously enables a more compact sensing system than known sensing systems. The sensing system comprises at least one less component than known sensing systems, thereby simplifying and reducing the cost of manufacture of the sensing system.

The electronic component may reduce an amount of electromagnetic radiation propagating directly from the emitter to the detector. The electronic component may be configured to at least partially block a line of sight between the emitter and the detector. Reducing the detection of electromagnetic radiation that propagates directly from the emitter to the detector without leaving the sensing system advantageously improves an accuracy of measurements performed using the sensing system. This is because radiation propagating directly from the emitter to the detector (i.e. without leaving the sensing system and interacting with an object that is to be sensed) contributes to measurement noise. The detector is suitable for detecting electromagnetic radiation that leaves the emitter, exits the sensing system via an optical aperture, interacts with (e.g. reflects from) one or more external objects and returns to the detector for detection.

The sensing system may be a time of flight sensing system and/or a proximity sensing system.

The emitter may be any kind of electromagnetic radiation source that is suitable for being incorporated into an electronic device such as, for example, a mobile phone. The emitter may be a diode or a laser such as a vertical cavity surface-emitting laser (VCSEL).

The detector could be any form of photodetector that is suitable for being incorporated into an electronic device such as, for example, a mobile phone. The detector may be a photodiode such as a single photon avalanche diode (SPAD).

The electronic component may be passive (e.g. a capacitor, inductor, resistor, transformer, transducer, etc.), active (e.g. a transistor, diode, a power source, electrostatic discharge device, etc.) and/or electromechanical (e.g. a switch, a piezoelectric device, a fuse, a connector, etc.).

The electronic component may comprise a capacitor configured to at least partially stabilise a voltage of the circuitry and/or reduce an effect of a field acting on the circuitry.

In known sensing systems, an electronic component such as a capacitor is generally not found on the same die or substrate as the circuitry of the sensing system. The capacitor of the sensing system of the present invention advantageously provides at least two functions of reducing the amount of electromagnetic radiation propagating directly from the emitter to the detector, and at least partially stabilising a voltage of the circuitry and/or reducing an effect of a field acting on the circuitry. The field may be an electric field. The field may be a magnetic field. The field may be an electromagnetic field. The field may be an external field, i.e. a field generated outside of the sensing system. The field may be an internal field, e.g. a magnetic field generated by an electrical current passing through the circuitry.

The electronic component may comprise an inductor configured to act as a filter for the circuitry.

The electronic component may comprise a resistor configured to act as a pull-up resistor or a pull-down resistor for the circuitry.

The electronic component may comprise a resistor and a capacitor configured to act as an RC filter for the circuitry.

The electronic component may comprise a diode configured to reduce an effect of a field acting on the circuitry.

The sensing system may comprise a die configured to house the circuitry of the sensing system. The electronic component may be located on the die.

The die may comprise CMOS components for use as an integrated circuit. The die may be located on a substrate of a printed circuit board. The closer the capacitor is located to the circuitry it is configured to interact with, the less the electrical resistance is between the electronic component and the circuitry, and the greater the performance of the electronic component.

The circuitry may comprise an integrated circuit of the sensing system. The die may house the integrated circuit.

The emitter and the detector may be located on the die.

The sensing system may comprise a substrate configured to provide electrical connections between the die and a printed circuit board of the sensing system. The emitter may be located on the substrate. The detector may be located on the die. The emitter may be located on the die. The detector may be located on the substrate.

The closer the electronic component is located to the circuitry (e.g. the die and/or substrate that house the emitter and/or the detector), the less the electrical resistance may be between the electronic component and the circuitry. Reducing the electrical resistance advantageously improves a performance of the electronic component. For example, if the electronic component comprises a capacitor, the ability of the capacitor to stabilise a voltage of the circuitry and/or reduce the effect of a field acting upon the circuitry may be improved by locating the capacitor on the same die and/or substrate as the circuitry.

The sensing system may comprise a filling provided between the electronic component and the sensing system.

The filling may comprise an ink. The filling may comprise a glue configured to secure the electronic component to the sensing system. The filling may be substantially opaque to wavelengths of radiation that are emitted by the emitter and detected by the detector. The filling may advantageously further reduce the amount of electromagnetic radiation propagating directly from the emitter to the detector.

The sensing system may comprise an electrode configured to receive the electronic component. The filling may comprise an electrically conductive adhesive configured to attach the electronic component to the electrode.

The sensing system may comprise two electrodes configured to receive the electronic component. The electronic component may comprise two electrodes configured to connect to the electrodes of the sensing system.

The sensing system may comprise an electrical contact and a conductive connector configured to connect the electronic component to the electrical contact. The filling may comprise a non-conductive adhesive configured to attach the electronic component to the sensing system. This sensing system may advantageously be less expensive to manufacture than other sensing systems.

The sensing system may be a time of flight sensing system. The sensing system may be a proximity sensing system.

An electronic device may comprise the sensing system. The electronic device may be a mobile electronic device such as a mobile phone or a tablet computer. The electronic device may be an industrial electronic device such as an automated manufacturing system or a robotic system such as those used in the automotive manufacturing industry. The electronic device may form part of an automated system for automating a house or a building.

A method of emitting and detecting electromagnetic radiation may comprise using the sensing system.

According to a second aspect of the present disclosure, there is provided a method of manufacturing a sensing system comprising providing an emitter configured to emit electromagnetic radiation, providing a detector configured to detect electromagnetic radiation, providing an electronic component configured to interact with a circuitry of the sensing system, and locating the electronic component at least partially between the emitter and the detector. The electronic component reduces an amount of electromagnetic radiation propagating from the emitter to the detector.

Finally, the present sensing system disclosed here utilises a novel approach at least in that an electronic component configured to interact with a circuitry of the sensing system is located at least partially between the emitter and the detector. The electronic component reduces an amount of electromagnetic radiation propagating from the emitter to the detector.

### Brief Description of the Preferred Embodiments

Some embodiments of the disclosure will now be described by way of example only and with reference to the accompanying drawings, in which:
Figures 1A and 1B schematically depict a cross-sectional side view and an exploded view of a known sensing system;
Figure 2 schematically depicts a view from above a portion of a known printed circuit board comprising an electronic component;
Figures 3A and 3B schematically depict a view from above and a cross-sectional view from the side of a sensing system according to an embodiment of the invention;
Figures 4A and 4B schematically depict a view from above and a cross-sectional view from the side of an alternative sensing system according to an embodiment of the invention; and,
Figure 5 shows a method of manufacturing a sensing system according to an embodiment of the invention.

### Detailed Description of the Preferred Embodiments

Generally speaking, the disclosure provides a sensing system that is suitable for use within an electronic device. The sensing system comprises an emitter configured to emit electromagnetic radiation and a detector configured to detect electromagnetic radiation. The sensing system also comprises an electronic component configured to interact with a circuitry of the sensing system. The electronic component is located at least partially between the emitter and the detector. The electronic component prevents at least some radiation from propagating directly from the emitter to the detector without leaving the sensing system. The electronic component may at least partially block a line of sight between the emitter and the detector. The electronic component may completely block a line of sight between the emitter and the detector.

Some examples of the solution are given in the accompanying figures.

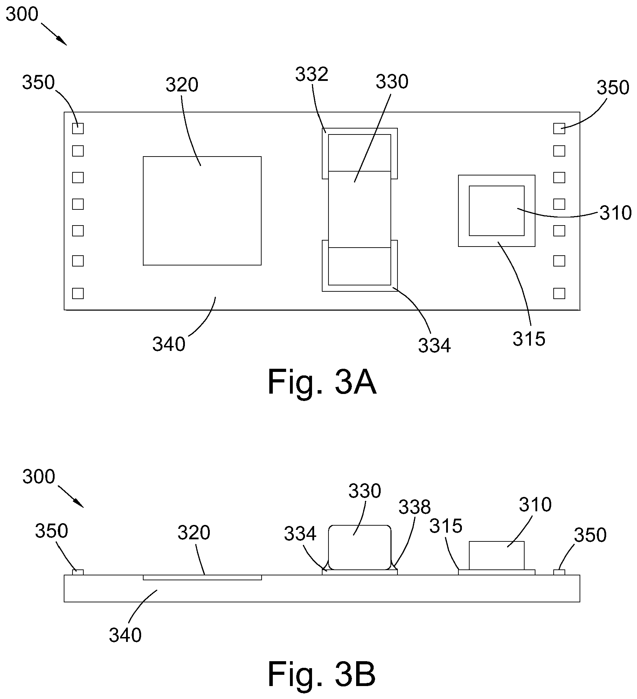

Figure 3A schematically depicts a view from above a sensing system 300 according to an embodiment of the invention. Figure 3B schematically depicts a cross-sectional view from the side of the sensing system 300 of Figure 3A. The sensing system 300 comprises an emitter 310 and a detector 320. The emitter 310 is configured to emit electromagnetic radiation. The emitter 310 may be any kind of electromagnetic radiation source suitable for being incorporated into an electronic device e.g. a diode or a laser such as a vertical cavity surface-emitting laser (VCSEL). The detector 320 is configured to detect electromagnetic radiation. The detector 320 may be configured to detect the electromagnetic radiation emitted by the emitter 310 after the electromagnetic radiation has exited the sensing system 300, interacted with (e.g. reflected from) an external object and propagated back to the detector 320. The detector 320 could be any form of photodetector, e.g. a photodiode such as a single photon avalanche diode (SPAD). The sensing system 300 may be a time of flight sensing system or a proximity sensing system. The sensing system 300 may be suitable for being incorporated into an electronic device such as, for example, a mobile phone or a tablet computer.

The time of flight sensing system may involve the emitter 310 emitting electromagnetic radiation, and at least some of that electromagnetic radiation interacting with (e.g. reflecting from) one or more external objects before propagating back to the detector 320 for detection. An amount of time between the emitter 310 emitting the radiation and the detector 320 detecting the radiation may be measured and distance between the electronic device and the one or more external objects may be determined using the known speed of light. The time of flight sensing system may be used for relatively high accuracy measurements. For example, if the time of flight sensing system was incorporated into a mobile phone comprising a camera, the time of flight sensing system may be used to determine a distance between the camera and an external object in order to adjust a focus of the camera to achieve an improved image of the object. Alternative uses of the time of flight sensing system include uses within the automotive industry, robotics, manufacturing, and automated processes. In the case of a time of flight sensing system, the sensing system 300 may further comprise a second detector (not shown) located proximate the emitter 310. The second detector may be configured to provide a reference detection value of background electromagnetic radiation for the time of flight sensing system.

The sensing system 300 may alternatively be a proximity sensing system in which the emitter 310 emits electromagnetic radiation, at least some of which exits the sensing system 300 and interacts with (e.g. reflects from) from one or more external objects before being incident on the detector 320 for detection. The amount of radiation emitted by the emitter 310 may be compared to the amount of radiation detected by the detector 320 in order to determine a distance between the electronic device and the one or more external objects. The proximity sensing system may be used for relatively low accuracy measurements. For example, if the proximity sensing system was incorporated into a mobile phone comprising a touch screen, the proximity sensing system may be used to determine whether the phone has been placed proximate a user's ear in order to change an input display on the touch screen to avoid unwanted input commands during a phone call.

The sensing system 300 further comprises an electronic component 330 configured to interact with a circuitry of the sensing system. The electronic component 330 may comprise a passive element (e.g. a capacitor, inductor, resistor, transformer, transducer, etc.), an active element (e.g. a transistor, diode, a power source, electrostatic discharge device, etc.) and/or an electromechanical element (e.g. a switch, a piezoelectric device, a fuse, a connector, etc.). For example, the electronic component 330 may comprise a capacitor configured to at least partially stabilize a voltage of the circuitry. During operation of the sensing system, unintended changes in voltage across the circuitry may occur. Example sources of unintended changes in voltage include unwanted power variation from a power supply, ripple voltages within the circuitry, changes in a current draw of the sensing system and/or changes in a current draw of an electronic device that the sensing system forms part of, and/or changes in voltage across the circuitry due to non-zero resistances and/or inductances within the circuitry. The capacitor may generally act as a localized voltage source and/or sink such that changes in current are at least partially counteracted by the capacitor. Alternatively and/or additionally, the capacitor may be configured to reduce an effect of a field (e.g. external and/or internal electromagnetic interference) acting on the circuitry. That is, the capacitor may be configured to improve an electromagnetic compatibility of the sensing system 300 with its electromagnetic environment. For example, an external magnetic field may negatively affect an operation of the sensing system 300 by generating unwanted currents within the circuitry. Alternatively or additionally, during operation the circuitry of the sensing system 300 may generate an internal magnetic field that may produce unwanted currents in the circuitry. The capacitor may act to at least partially counteract the unwanted currents acting on the circuitry.

As another example, the electronic component 330 may comprise an inductor. The inductor may, for example, be configured to act as a filter for the circuitry of the sensing system 300. For example, the inductor may be configured to filter out a range of frequencies of alternating current to prevent certain frequencies acting on certain parts of the circuitry.

As a further example, the electronic component 330 may comprise a resistor. The resistor may, for example, be configured to act as a pull-up resistor or a pull-down resistor for the circuitry of the sensing system 300. That is, the resistor may be configured to provide a well-defined voltage at an input and/or output of the circuitry.

As another example, the electronic component may comprise a resistor and a capacitor configured to act as a filter network (i.e. an RC filter) for the circuitry of the sensing system 300.

As a further example, the electronic component 330 may comprise a diode. The diode may, for example, be configured to reduce an effect of a field (e.g. external and/or internal electromagnetic interference) acting on the circuitry. That is, the diode may be configured to improve an electromagnetic compatibility of the sensing system 300 with its electromagnetic environment. The diode may act to at least partially counteract the effects of unwanted currents acting on the circuitry.

Referring again to Figures 1A, 1B, known sensing systems 100 include a shield 180 located between the emitter 110 and the detector 120. The sole purpose of the shield 180 is to at least partially block electromagnetic radiation from propagating directly from the emitter 110 to the detector 120.

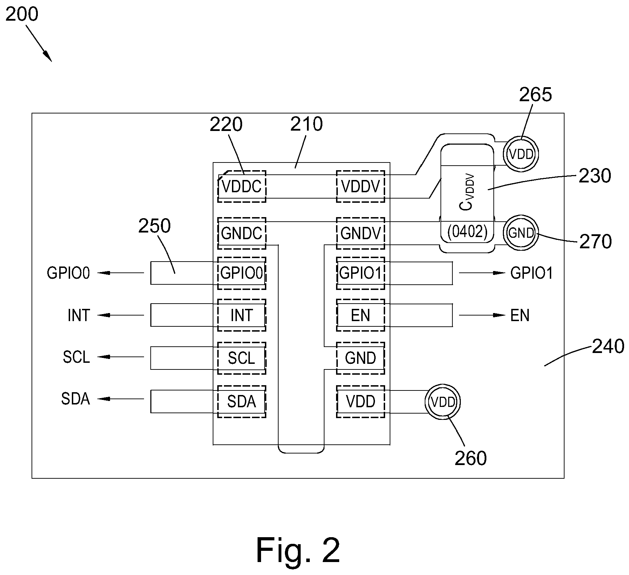

Figure 2 schematically depicts a view from above a portion of a known printed circuit board 200 comprising a capacitor 230. The printed circuit board 200 may share the same die 240 and/or the same substrate (not shown) as the known sensing system shown in Figures 1A and 1B. The printed circuit board 200 comprises an integrated circuit 210 having a plurality of signal inputs and outputs 220. First and second voltage source connections 260, 265, ground connection 270 and conductive paths 250 allow for the provision of electrical energy and signals to the integrated circuit 210. The capacitor 230 is provided on the printed circuit board 200 outside of and away from the sensing system (not shown in Figure 2). The capacitor 230 has the sole function of interacting with the integrated circuit 210 (e.g. to stabilise a voltage of the integrated circuit 210). The capacitor 230 may be separated from the integrated circuit 210 by a distance (e.g. about 300 µm) determined by manufacturing tolerances (e.g. the accuracy of a pick and place tool used to manufacture the printed circuit board 200).

Referring again to Figures 3A and 3B, by locating the electronic component 330 at least partially between the emitter 310 and the detector 320 the electronic component 330 not only performs its standard function of interacting with a circuitry of the sensing system 300 but also reduces an amount of electromagnetic radiation propagating directly from the emitter 310 to the detector 320. This removes the need for the shield of known sensing systems, which advantageously enables a more compact sensing system 300 compared to known sensing systems 100. The sensing system 300 according to the invention comprises at least one less component than known sensing systems 100, thereby simplifying and reducing the cost of manufacture of the sensing system 300. The electronic component 330 may be configured to at least partially block a line of sight between the emitter 310 and the detector 320. Reducing the amount of radiation that propagates directly from the emitter 310 to the detector 320 advantageously improves an accuracy of the sensing system 300 by removing unwanted noise from the detector signal.

The electronic component 330 may comprise one or more materials that are substantially opaque to wavelengths of radiation that are emitted by the emitter 310 and detected by the detector 320. For example, the emitter 310 and the detector 320 may be configured to emit and detect visible and/or infrared wavelengths of electromagnetic radiation respectively. For example, the emitter 310 and the detector 320 may be configured to emit and detect radiation having a wavelength within the range of about 800 nm to about 1000 nm respectively. In some embodiments, it may be preferable for the emitter 310 and the detector 320 to emit and detect non-visible wavelengths of radiation such that the radiation used by the sensing system 300 is not detectable to the naked eye.

The electronic component 330 is sized, shaped and positioned to at least partially block radiation that would otherwise propagate directly from the emitter 310 to the detector 320. The electronic component 330 may be sized, shaped and positioned to substantially block an entire line of sight or field of illumination between the emitter 310 and the detector 320. A size, shape and position of the electronic component 330 may therefore at least partially depend on a geometry of the sensing system 300. For example, the size, shape and position of the electronic component 330 may be selected based on a size, shape and position of the emitter 310; a size, shape and position of the detector 320; and/or, a space between the emitter 310 and the detector 320 across which emitted radiation may propagate. It will be appreciated that the dimensions and geometries of various components of the sensing system 300 may vary greatly between different use cases. In general, the electronic component 330 is sized, shaped and positioned to at least partially block a path of radiation from the emitter 310 to the detector 320. The electronic component 330 may be a standard electronic component having a standard size. For example, the electronic component may be a 0402 imperial capacitor having a length of about 1.0 mm and a width of about 0.5 mm, or a 0201 imperial capacitor having a length of about 0.6 mm and a width of about 0.3 mm.

A range of angles across which the radiation leaves the emitter 320 and/or a range of angles across which radiation may enter the detector 320 may also at least partially determine the size, shape and position of the electronic component 330. In general, a height of the electronic component 330 may be greater than a height of the emitter 310.

The size, shape and position of the electronic component 330 are preferably selected such that electromagnetic radiation emitted by the emitter 310 that does not exit the sensing system 300 is prevented from reaching the detector 310 by the electronic component 330. The sensing system 300 is generally configured such that a measurement portion of radiation emitted by the emitter 310 exits the sensing system 300, interacts with the outside environment (e.g. reflect from objects), and returns to the sensing system 300 to be detected by the detector 320. The electronic component 330 does not prevent the measurement portion of radiation from reaching the detector 320.

The sensing system 300 may comprise a cap such as the cap 190 shown in Figures 1A and 1B. A portion of the cap may be shaped to abut an upper surface of the electronic component 330 and thereby substantially prevent radiation propagating directly from the emitter 310 to the detector 320. The sensing system 300 may also comprise first and second casings (not shown), such as the first and second casings 182, 184 shown in Figures 1A and 1B.

In the example of Figures 3A and 3B, the electronic component 330, the emitter 310 and the detector 320 are located on a single die 340. The die 340 is configured to house a circuitry (e.g. an integrated circuit) of the sensing system 300. The die 340 may comprise complementary metal-oxide semiconductor (CMOS) circuitry. The die 340 may be located on a substrate (not shown) of a printed circuit board (not shown). The closer the electronic component 330 is located to the circuitry of the sensing system 300 (e.g. the die 340), the lower the electrical resistance may be between the electronic component 330 and the circuitry of the sensing system 300. This may improve a performance of the electronic component 330. By locating the electronic component 330 on the same die 340 and/or substrate (not shown) as the circuitry of the sensing system 300, the lengths of conductive paths between said components is reduced compared to known sensing systems. This reduces the electrical resistance associated with the conductive paths compared to known sensing systems, which advantageously improves a performance of the electronic component 330 compared to known sensing systems.

It may be preferable to maintain a relatively thin (e.g. less than about 2 mm) die 340 because the die may be a relatively expensive component of the sensing system 300 to manufacture. Locating a larger electronic component 330 (e.g. a capacitor) at least partially between the emitter 310 and the detector 320 may therefore be advantageous because smaller electronic components (e.g. diodes) may be incorporated into the die 340 without having to increase a thickness of the die 340 to accommodate the smaller components.

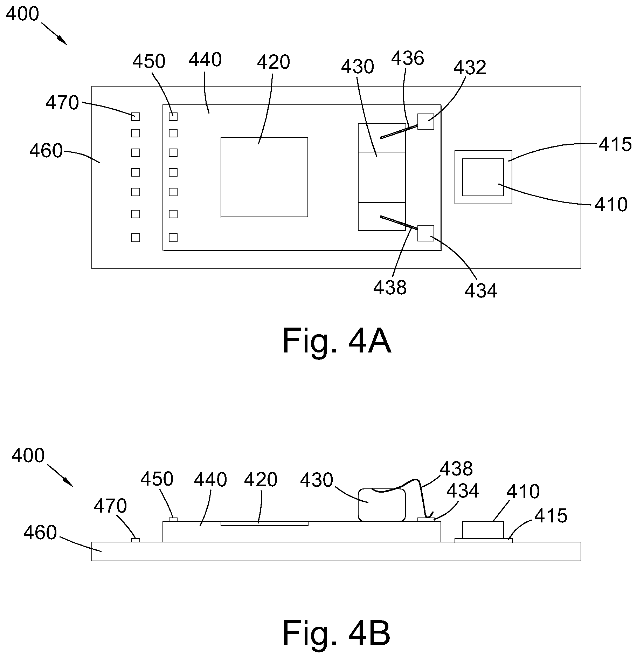

The die 340 comprises electrical contacts 350 for electrically connecting the sensing system 300 to other electronics, e.g. a processor of an electronic device (not shown) that incorporates the sensing system 300. The sensing system 300 comprises an emitter electrode 315 configured to receive the emitter 310. The emitter electrode 315 is located on the die 340. The sensing system 300 further comprises two electrodes 332, 334 configured to receive the electronic component 330. The electrodes 332, 334 are located on the die 340. The electrodes 332, 334 may increase a surface area of contact between the electronic component 330 and the sensing system 300 compared to using conductive connectors such as wire bonding. This may advantageously improve an electrical connection between the electronic component 330 and the sensing system 300 compared to other ways of electrically connecting the electronic component 330 to the sensing system 300. The electrodes 332, 334 may, for example, comprise gold plates. The electronic component 330 may itself comprise two electrodes (not shown) for contacting the electrodes 332, 334 of the sensing system 300. The sensing system 300 may alternatively comprise two electrical contacts and two conductive connectors (such as the electronic component contacts 432, 434 and first and second conductive connectors 436, 438 shown in Figures 4A and 4B) spaced away from the electronic component 330 that connect the electronic component 330 to the electrical contacts.

A filling 338 may be provided between the electronic component 330 and the sensing system 300. The filling 338 may be configured to further reduce the propagation of electromagnetic radiation directly from the emitter 310 to the detector 320 without leaving the sensing system 300. The filling 338 may comprise an ink and/or a glue configured to secure the electronic component 330 to the sensing system 300. In the example of Figures 3A and 3B, the filling 338 comprises an electrically conductive adhesive between the electronic component 330 and the electrodes 332, 334. The electrically conductive adhesive advantageously provides multiple functions such as attaching the electronic component 330 to the sensing system 300, providing a conductive path between the electronic component 330 and the electrodes 332, 334, and further reducing the detection of electromagnetic radiation that would otherwise propagate directly from the emitter 310 to the detector 320 without leaving the sensing system 300.

Figures 4A and 4B schematically depict a view from above and a cross-sectional view from the side of an alternative sensing system 400 according to an embodiment of the invention. The sensing system 400 of Figures 4A and 4B shares many common features with the sensing system 300 of Figures 3A and 3B. The sensing system 400 comprises an emitter 410 and a detector 420. The emitter 410 is configured to emit electromagnetic radiation. The emitter 410 may be any kind of electromagnetic radiation source, e.g. a diode or a laser such as a vertical cavity surface-emitting laser (VCSEL). The detector 420 is configured to detect electromagnetic radiation. The detector 420 may be configured to detect the electromagnetic radiation emitted by the emitter 410 after the electromagnetic radiation has interacted with (e.g. reflected from) an object that is to be sensed by the sensing system 400. The detector 420 may be any form of photodetector e.g. a photodiode such as a single photon avalanche diode (SPAD). The sensing system 400 is suitable for forming part of an electronic device, such as a mobile phone or tablet computer. The sensing system 400 may be a time of flight sensing system or a proximity sensing system as discussed above.

The sensing system 400 comprises an electronic component 430 configured to interact with a circuitry of the sensing system 400. The electronic component 430 may be a passive, active and/or electromechanical element as discussed above. For example, the electronic component 430 may comprise a capacitor configured to at least partially stabilize a voltage of the circuitry and/or reduce an effect of a field (e.g. external electromagnetic interference) acting on the circuitry of the sensing system 400.

The electronic component 430 is located at least partially between the emitter 410 and the detector 420. By locating the electronic component 430 at least partially between the emitter 410 and the detector 420, the electronic component 430 not only performs its standard function of interacting with a circuitry of the sensing system 400, but also reduces the detection of electromagnetic radiation that would otherwise propagate directly from the emitter 410to the detector 420. This advantageously enables a more compact, simplified and relatively inexpensive sensing system 400 compared to known sensing systems. The electronic component 430 may be configured to at least partially block a line of sight between the emitter 410 and the detector 420. The electronic component 430 may be configured to completely block a line of sight between the emitter 410 and the detector 420.

As discussed above, the electronic component 430 of the sensing system 400 of Figures 4A and 4B may be formed of different materials in order to make the electronic component 430 substantially opaque to the wavelengths of radiation that are emitted by the emitter 410 and detected by the detector 410.

As discussed above, a size, shape and/or a position of the electronic component 430 may at least partially depend on a size, shape and position of the emitter 410, a size, shape and position of the detector 420, and a space between the emitter 410 and the detector 420 across which radiation may propagate. The size, shape and/or position of the electronic component 430 is selected such that the amount of electromagnetic radiation propagating directly from the emitter 410 to the detector 420 is reduced. That is, the electronic component 430 acts to absorb and/or redirect electromagnetic radiation that would otherwise propagate directly from the emitter 410 to the detector 420.

The sensing system 400 may comprise a cap (not shown in Figures 4A and 4B) such as the cap 190 shown in Figures 1A and 1B. A portion of the cap may be shaped to abut the electronic component 430 and substantially prevent radiation propagating directly from the emitter 410 to the detector 420. The sensing system 400 may also comprise first and second casings (not shown), such as the first and second casings 182, 184 shown in Figures 1A and 1B.

In the example of Figures 4A and 4B, the electronic component 430 and the detector 420 are located on a single die 440, and the emitter 410 and the die 440 are located on a single substrate 460. Having the electronic component 430, the emitter 410 and the detector 420 on the same substrate keeps the electronic component 430 close to the circuitry of the sensing system 400. This advantageously reduces the electrical resistance between the electronic component 430 and the circuitry of the sensing system 400, thereby improving the performance of the electronic component 430. For example, if the electronic component 430 comprised a capacitor, the performance of the capacitor at stabilising voltage and/or reducing the effect of a field (e.g. external or internal electromagnetic interference) acting upon the circuitry of the sensing system 400 may be improved.

In the example of Figures 4A and 4B, the sensing system 400 comprises first and second electronic component contacts 432, 434 spaced away from the electronic component 430 on the die 440 and first and second conductive connectors 436, 438 that connect the electronic component 430 to the electronic component contacts 432, 434. The sensing system 400 may alternatively comprise two electrodes (such as the electrodes 332, 334 shown in Figures 3A and 3B) configured to receive the electronic component 430, thereby removing the need for the first and second conductive connectors 436, 438.

The sensing system 400 may comprise a filling (not shown) provided between the electronic component 430 and the sensing system 400 to further prevent electromagnetic radiation from propagating directly from the emitter 410 to the detector 420. In the example of Figures 4A and 4B, the filling comprises a non-conductive adhesive between the electronic component 430 and the sensing system 400.

The die 440 comprises electrical contacts 450 for electrically connecting the sensing system 400 to electrical contacts 470 of the substrate 460. The substrate 460 may comprise further electrical contacts (not shown), e.g. on the bottom of the substrate 460, to connect the sensing system 400 to other electronics such as an integrated circuit, e.g. a processor of an electronic device (not shown). The substrate 460 comprises an emitter electrode 415 configured to receive the emitter 410.

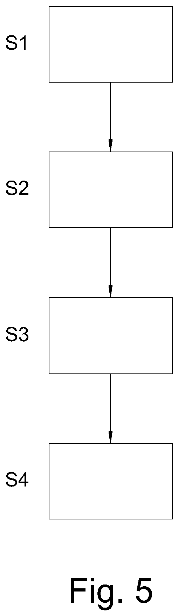

Figure 5 shows a method of manufacturing a sensing system according to an embodiment of the invention. A first step S1 of the method comprises providing an emitter to emit electromagnetic radiation. A second step S2 of the method comprises providing a detector to detect electromagnetic radiation. A third step S3 of the method comprises providing an electronic component to interact with a circuitry of the sensor. A fourth step S4 of the method comprises locating the electronic component at least partially between the emitter and the detector to reduce an amount of electromagnetic radiation emitted by the emitter from being detected by the detector.

The method may also comprise providing a die, providing a substrate and attaching the die to the substrate. The die may comprise the emitter. The substrate may comprise the emitter. Electrical connections between the die and the substrate may be provided, e.g. using wire bonding, and the detector and the electronic component may be provided on the die. First and second casings for the detector and emitter may be provided, and a cap may be positioned to abut the electronic component. The cap may be glued to the sensing system to hold the casings in place.

Embodiments of the present disclosure can be employed in many different applications including time of flight or proximity sensors in electronic devices, for example, in consumer goods (e.g. mobile phones and tablet computers), housing and building automation systems, manufacturing systems and product lines, robotics, automotive, and other industries.

List of reference numerals:
100 - Known sensing system
110 - Emitter
120 - Detector
130 - First die
140 - Second die
150 - Electrical contacts (die)
160 - Substrate
170 - Electrical contacts (substrate)
180 - Shield
182 - First casing
184 - Second casing
186 - Lens
190 - Cap
192 - First aperture
194 - Second aperture
200 - Known printed circuit board
210 - Integrated circuit
220 - Inputs/Outputs
230 - Capacitor
240 - Die
250 - Conductive paths
260 - First voltage source connection
265 - Second voltage source connection
270 - Ground connection
300 - Sensing system
310 - Emitter
315 - Emitter electrode
320 - Detector
330 - Electronic component
332 - First electrode
334 - Second electrode
338 - Filling
340 - Die
350 - Electrical contacts
400 - Sensing system
410 - Emitter
415 - Emitter electrode
420 - Detector
430 - Electronic component
432 - First electronic component contact
434 - Second electronic component contact
436 - First conductive connector
438 - Second conductive connector
440 - Die
450 - Electrical contacts (die)
460 - Substrate
470 - Electrical contacts (substrate)
S1-S4 - First, second, third and fourth method steps

The skilled person will understand that in the preceding description and appended claims, positional terms such as 'above', 'along', 'side', etc. are made with reference to conceptual illustrations, such as those shown in the appended drawings. These terms are used for ease of reference but are not intended to be of limiting nature. These terms are therefore to be understood as referring to an object when in an orientation as shown in the accompanying drawings.

Although the disclosure has been described in terms of preferred embodiments as set forth above, it should be understood that these embodiments are illustrative only and that the claims are not limited to those embodiments. Those skilled in the art will be able to make modifications and alternatives in view of the disclosure, which are contemplated as falling within the scope of the appended claims.

## Claims

1. A sensing system (300, 400) comprising:
an emitter (310, 410) configured to emit electromagnetic radiation:
a detector (320,420) configured to detect electromagnetic radiation; and
an electronic component (330, 430) configured to interact with a circuitry of the sensing system, wherein the electronic component (330, 430) is located at least partially between the emitter (310,410) and the detector (320, 420), and wherein the electronic component (330, 430) reduces an amount of electromagnetic radiation propagating from the emitter (310, 410) to the detector (320, 420); and
wherein the sensing system (300, 400) is such that a measurement portion of radiation emitted by the emitter (310, 410) exits the sensing system (300, 400), interacts with the outside environment, and returns to the sensing system (300, 400) to be detected by the detector (320, 420).

2. The sensing system of claim 1, wherein the electronic component comprises a capacitor configured to at least partially stabilise a voltage of the circuitry and/or reduce an effect of a field acting on the circuitry.

3. The sensing system of claim 1, wherein the electronic component comprises an inductor configured to act as a filter for the circuitry.

4. The sensing system of claim 1, wherein the electronic component comprises a resistor configured to act as a pull-up resistor or a pull-down resistor for the circuitry.

5. The sensing system of claim 1, wherein the electronic component comprises a resistor and a capacitor configured to act as an RC filter for the circuitry.

6. The sensing system of claim 1, wherein the electronic component comprises a diode configured to reduce an effect of a field acting on the circuitry.

7. The sensing system of claim 1, comprising a die (340, 440) configured to house the circuitry of the sensing system, wherein the electronic component is located on the die (340, 440).

8. The sensing system of claim 7, wherein the emitter and the detector are located on the die.

9. The sensing system of claim 7, comprising a substrate configured to provide electrical connections between the die and a printed circuit board of the sensing system, wherein the emitter is located on the substrate and the detector is located on the die.

10. The sensing system of claim 1, comprising a filling (338) provided between the electronic component and the sensing system.

11. The sensing system of claim 10, comprising an electrode (332, 334) configured to receive the electronic component, wherein the filling comprises an electrically conductive adhesive configured to attach the electronic component to the electrode.

12. The sensing system of claim 10, comprising an electrical contact (350, 450) and a conductive connector configured to connect the electronic component to the electrical contact, wherein the filling comprises a non-conductive adhesive configured to attach the electronic component to the sensing system.

13. The sensing system of claim 1, wherein the sensing system is a time of flight sensing system.

14. The sensing system of claim 1, wherein the sensing system is a proximity sensing system.

15. An electronic device comprising the sensing system of claim 1.

16. The electronic device of claim 15, wherein the electronic device is a mobile phone.

17. A method of manufacturing a sensing system (300, 400) comprising:
providing an emitter (310, 410) configured to emit electromagnetic radiation
providing a detector (320, 420) configured to detect electromagnetic radiation;
providing an electronic component (330, 430) configured to interact with a circuitry of the sensing system (300, 400);
locating the electronic component (330, 430) at least partially between the emitter (310, 410) and the detector (320, 420), wherein the electronic component reduces an amount of electromagnetic radiation propagating from the emitter (310, 410) to the detector (320, 420); and
wherein the sensing system (300, 400) is such that a measurement portion of radiation emitted by the emitter (310, 410) exits the sensing system (300, 400), interacts with the outside environment, and returns to the sensing system (300, 400) to be detected by the detector (320, 420).

## Patentansprüche

1. Sensorsystem (300, 400), Folgendes umfassend:
einen Emitter (310, 410), welcher eingerichtet ist, um elektromagnetische Strahlung zu emittieren;
einen Detektor (320, 420), welcher eingerichtet ist, um elektromagnetische Strahlung zu detektieren; und
eine elektronische Komponente (330, 430), welche eingerichtet ist, um mit einer Schaltung des Sensorsystems zusammenzuwirken, wobei die elektronische Komponente (330, 430) mindestens teilweise zwischen dem Emitter (310, 410) und dem Detektor (320, 420) angeordnet ist und wobei die elektronische Komponente (330, 430) eine Menge elektromagnetischer Strahlung reduziert, welche sich von dem Emitter (310, 410) zu dem Detektor (320, 420) ausbreitet; und
wobei das Sensorsystem (300, 400) derartig ist, dass ein Messanteil der Strahlung, welche von dem Emitter (310, 410) emittiert wird, das Sensorsystem (300, 400) verlässt, mit der Außenumgebung wechselwirkt und zu dem Sensorsystem (300, 400) zurückkehrt, um von dem Detektor (320, 420) detektiert zu werden.

2. Sensorsystem nach Anspruch 1, wobei die elektronische Komponente einen Kondensator umfasst, welcher eingerichtet ist, um eine Spannung der Schaltung mindestens teilweise zu stabilisieren und/oder eine Wirkung eines Felds zu reduzieren, welches auf die Schaltung wirkt.

3. Sensorsystem nach Anspruch 1, wobei die elektronische Komponente eine Induktivität umfasst, welche eingerichtet ist, um als ein Filter für die Schaltung zu wirken.

4. Sensorsystem nach Anspruch 1, wobei die elektronische Komponente einen Widerstand umfasst, welcher eingerichtet ist, um als ein Pull-up-Widerstand oder als ein Pull-down-Widerstand für die Schaltung zu wirken.

5. Sensorsystem nach Anspruch 1, wobei die elektronische Komponente einen Widerstand und einen Kondensator umfasst, welche eingerichtet sind, um als ein RC-Filter für die Schaltung zu wirken.

6. Sensorsystem nach Anspruch 1, wobei die elektronische Komponente eine Diode umfasst, welche eingerichtet ist, um eine Wirkung eines Felds zu reduzieren, welches auf die Schaltung wirkt.

7. Sensorsystem nach Anspruch 1, umfassend einen Chip (340, 440), welcher eingerichtet ist, um die Schaltung des Sensorsystems zu beherbergen, wobei die elektronische Komponente auf dem Chip (340, 440) angeordnet ist.

8. Sensorsystem nach Anspruch 7, wobei der Emitter und der Detektor auf dem Chip angeordnet sind.

9. Sensorsystem nach Anspruch 7, umfassend ein Substrat, welches eingerichtet ist, um elektrische Verbindungen zwischen dem Chip und einer Leiterplatte des Sensorsystems bereitzustellen, wobei der Emitter auf dem Substrat angeordnet ist und der Detektor auf dem Chip angeordnet ist.

10. Sensorsystem nach Anspruch 1, umfassend eine Füllung (338), welche zwischen der elektronischen Komponente und dem Sensorsystem bereitgestellt ist.

11. Sensorsystem nach Anspruch 10, umfassend eine Elektrode (332, 334), welche eingerichtet ist, um die elektronische Komponente aufzunehmen, wobei die Füllung einen elektrisch leitfähigen Klebstoff umfasst, welcher eingerichtet ist, um die elektronische Komponente an der Elektrode zu befestigen.

12. Sensorsystem nach Anspruch 10, umfassend einen elektrischen Kontakt (350, 450) und einen leitfähigen Verbinder, welcher eingerichtet ist, um die elektronische Komponente mit dem elektrischen Kontakt zu verbinden, wobei die Füllung einen nichtleitenden Klebstoff umfasst, welcher eingerichtet ist, um die elektronische Komponente an dem Sensorsystem zu befestigen.

13. Sensorsystem nach Anspruch 1, wobei das Sensorsystem ein Flugzeitsensorsystem ist.

14. Sensorsystem nach Anspruch 1, wobei das Sensorsystem ein Näherungssensorsystem ist.

15. Elektronische Vorrichtung, umfassend das Sensorsystem nach Anspruch 1.

16. Elektronische Vorrichtung nach Anspruch 15, wobei die elektronische Vorrichtung ein Mobiltelefon ist.

17. Verfahren zum Herstellen eines Sensorsystems (300, 400), Folgendes umfassend:
Bereitstellen eines Emitters (310, 410), welcher eingerichtet ist, um elektromagnetische Strahlung zu emittieren;
Bereitstellen eines Detektors (320, 420), welcher eingerichtet ist, um elektromagnetische Strahlung zu detektieren;
Bereitstellen einer elektronischen Komponente (330, 430), welche eingerichtet ist, um mit einer Schaltung des Sensorsystems (300, 400) zusammenzuwirken;
Anordnen der elektronischen Komponente (330, 430) mindestens teilweise zwischen dem Emitter (310, 410) und dem Detektor (320, 420),
wobei die elektronische Komponente eine Menge elektromagnetischer Strahlung reduziert, welche sich von dem Emitter (310, 410) zu dem Detektor (320, 420) ausbreitet; und
wobei das Sensorsystem (300, 400) derartig ist, dass ein Messanteil der Strahlung, welche von dem Emitter (310, 410) emittiert wird, das Sensorsystem (300, 400) verlässt, mit der Außenumgebung wechselwirkt und zu dem Sensorsystem (300, 400) zurückkehrt, um von dem Detektor (320, 420) detektiert zu werden.

## Revendications

1. Système de capteur (300, 400) comprenant :
un émetteur (310, 410) configuré pour émettre un rayonnement électromagnétique ;
un détecteur (320, 420) configuré pour détecter un rayonnement électromagnétique ; et
un composant électronique (330, 430) configuré pour interagir avec un circuit du système de capteur, dans lequel le composant électronique (330, 430) se situe au moins partiellement entre l'émetteur (310, 410) et le détecteur (320, 420), et dans lequel le composant électronique (330, 430) réduit une quantité du rayonnement électromagnétique propagé à partir de l'émetteur (310, 410) vers le détecteur (320, 420) ;
dans lequel le système de capteur (300, 400) est tel qu'une portion de mesure d'un rayonnement émis par l'émetteur (310, 410) sort du système de capteur (300, 400), interagit avec l'environnement extérieur et revient vers le système de capteur (300, 400) pour être détectée par le détecteur (320, 420).

2. Système de capteur selon la revendication 1, dans lequel le composant électronique comprend un condensateur configuré pour stabiliser au moins partiellement une tension du circuit et/ou pour réduire un effet d'un champ agissant sur le circuit.

3. Système de capteur selon la revendication 1, dans lequel le composant électronique comprend un inducteur configuré pour agir comme un filtre pour le circuit.

4. Système de capteur selon la revendication 1, dans lequel le composant électronique comprend une résistance configurée pour agir comme une résistance d'excursion haute ou comme une résistance d'excursion basse pour le circuit.

5. Système de capteur selon la revendication 1, dans lequel le composant électronique comprend une résistance et un condensateur configuré pour agir comme un filtre RC pour le circuit.

6. Système de capteur selon la revendication 1, dans lequel le composant électronique comprend une diode configurée pour réduire un effet d'un champ agissant sur le circuit.

7. Système de capteur selon la revendication 1, comprenant une puce (340, 440) configurée pour accueillir le circuit du système de capteur, dans lequel le composant électronique se situe sur la puce (340, 440).

8. Système de capteur selon la revendication 7, dans lequel l'émetteur et le détecteur se situent sur la puce.

9. Système de capteur selon la revendication 7, comprenant un substrat configuré pour fournir des connexions électriques entre la puce et une carte de circuit imprimé du système de capteur, dans lequel l'émetteur se situe sur le substrat et le détecteur se situe sur la puce.

10. Système de capteur selon la revendication 1, comprenant un remplissage (338) disposé entre le composant électronique et le système de capteur.

11. Système de capteur selon la revendication 10, comprenant une électrode (332, 334) configurée pour recevoir le composant électronique, dans lequel le remplissage comprend un adhésif électriquement conducteur configuré pour fixer le composant électronique à l'électrode.

12. Système de capteur selon la revendication 10, comprenant un contact électrique (350, 450) et un connecteur conducteur configuré pour connecter le composant électronique au contact électrique, dans lequel le remplissage comprend un adhésif non conducteur configuré pour fixer le composant électronique au système de capteur.

13. Système de capteur selon la revendication 1, dans lequel le système de capteur est un système de capteur de durée de vol.

14. Système de capteur selon la revendication 1, dans lequel le système de capteur est un système de capteur de proximité.

15. Dispositif électronique comprenant le système de capteur selon la revendication 1.

16. Dispositif électronique selon la revendication 15, dans lequel le dispositif électronique est un téléphone mobile.

17. Procédé de fabrication d'un système de capteur (300, 400) comprenant :
la fourniture d'un émetteur (310, 410) configuré pour émettre un rayonnement électromagnétique ;
la fourniture d'un détecteur (320, 420) configuré pour détecter un rayonnement électromagnétique ;
la fourniture d'un composant électronique (330, 430) configuré pour interagir avec un circuit du système de capteur (300, 400) ;
le placement du composant électronique (330, 430) au moins partiellement entre l'émetteur (310, 410) et le détecteur (320, 420),
dans lequel le composant électronique réduit une quantité du rayonnement électromagnétique se propageant à partir de l'émetteur (310, 410) vers le détecteur (320, 420) ; et
dans lequel le système de capteur (300, 400) est tel qu'une portion de mesure d'un rayonnement émis par l'émetteur (310, 410) sort du système de capteur (300, 400), interagit avec l'environnement extérieur et revient vers le système de capteur (300, 400) pour être détectée par le détecteur (320, 420).
